# EUROPEAN PATENT SPECIFICATION

(11) **EP 3 491 442 B1**
(45) Date of publication and mention of the grant of the patent: **25.11.2026**
(21) Application number: 17740857.2
(22) Date of filing: 06.07.2017
(51) Int. Cl.: G02B 6/44

(54) **SEALED FIBER OPTIC/ELECTRICAL DISTRIBUTION DEVICE**
VERSIEGELTE FASEROPTISCHE/ELEKTRISCHE VERTEILUNGSVORRICHTUNG
DISPOSITIF DE DISTRIBUTION FIBRE OPTIQUE / ÉLECTRIQUE SCELLÉ

(30) Priority: 29.07.2016 US 201615223329
(43) Date of publication of application: 05.06.2019
(73) Proprietor: Corning Research & Development Corporation, Hickory, North Carolina 28601 (US)
(72) Inventor: DURAN, Christian Shane, Ft. Worth, Texas 76131 (US); KEENUM, John Austin, Haltom City, Texas 76137 (US); REED, Edward Joseph, North Richland Hills, Texas 76180 (US); TENHOLDER, Rodger Alan, Saginaw, Texas 76179 (US)
(74) Representative: Epping - Hermann - Fischer
(86) International application number: PCT/US2017/040840
(87) International publication number: WO 2018/022270

(56) References cited:
- WO-A1-2016/049242
- US-A1- 2006 153 362
- US-A1- 2007 272 440
- US-A1- 2016 091 683
- US-A1- 2016 091 684
- US-B1- 6 457 874

## Description

### CROSS REFERENCE TO RELATED APPLICATIONS

This application claims the benefit of priority of U.S. Patent Application Serial No. 15/223,329, filed July 29, 2016.

### FIELD

The disclosure relates generally to fiber optic distribution devices, and more particularly to sealed fiber optic distribution devices having an optical/electrical converter used to advance the conversion point between the fiber optic and the existing electrical telecommunication networks closer to the subscriber.

### BACKGROUND

As a result of the ever-increasing demand for broadband communications involving voice, video and data transmission, telecommunication and cable media service providers and/or operators have increasingly relied on fiber optics to provide large bandwidth telecommunication service to their subscribers. Fiber optic solutions have become the main part of telecommunication networks. Optical cables can transmit voice, data and video signals over very long distances at very high speed. Because of this, developments in fiber optic telecommunication networks have consistently focused on extending the optical fiber closer to the subscriber to the point that currently some subscribers can be connected directly to the fiber optic network through FTTx (fiber to the specific location "x") technology, including FTTH technology (fiber-to-the-home), which provides an "all optical" communication network right to the subscribers at their homes. This dynamic subscriber bandwidth demand exists whether optical fiber reaches all the way to the subscriber or not.
The disclosure of document US 2007/0272440 A1 relates to an enclosure for housing communications equipment which includes at least one cable port for receiving a service provider cable, a subscriber cable, and a ground cable. The enclosure further includes a housing and a grounding post that extends from a base within the housing interior volume and that is electrically connectable with the ground cable. Active electronic components located in the housing interior volume connect the service provider cable with the subscriber cable.
Document US 2016/0091683 A1 discloses an enclosable box for housing components from more than one telecommunication systems including a first and a second housing portion. A box mounting hinge connects the first housing portion and the second housing portion and a compartment panel mounting hinge connects an internal telecommunication component compartment with one of the first and second housing portions. The box mounting hinge may be configured to allow the first housing portion and second housing portion to open and close in a clam like manner.
Document US 2006/0153362 A1 discloses a network interface device for a fiber optic communications network for housing optical, electrical and/or coaxial connections and active and/or passive components. The network interface device includes a base and a movable panel defining a connections area and a components area. In one embodiment, a first base defines a first compartment for housing the panel and a second base defining a second compartment for storing drop cable slack, the first base being movably attached to the second base to provide access to the drop cable slack without disturbing the connections.
In document US 6457874 B1 a wall mountable mixed media outlet is described that includes ports that are typically designed to provide separate access to an electrical network and to an optical network. The wall mounted outlet can therefore permit a telephone to be connected to the electrical network, and a computer to be connected to the optical network. Alternatively, the outlet can permit a telephone to also be connected to either the same or a different optical network than the computer. The mixed media outlet includes a housing adapted to be wall mounted and first and second ports that are disposed within openings defined by the housing, such as a data port and a voice port.
Document WO 2016/049242 A1 discloses a further enclosable box for housing components from more than one telecommunication systems including a first housing portion, a second housing portion, a box mounting hinge that connects the first housing portion and the second housing portion, an internal telecommunication component compartment panel, a compartment panel mounting hinge that connects the internal telecommunication component compartment with one of the first and second housing portions. The box mounting hinge is configured to allow the first housing portion and second housing portion to open and close in a clam like manner.
Document US 2016/091684 A1 discloses a closure is installed at a network distribution point to facilitate upgrading a subscriber network to extend optical fibers closer to the subscribers. The closure may include active equipment to convert optical signals to electrical signals. The closure enables a plug-and-play connection to the active equipment to facilitate installing and/or upgrading active equipment at the closure.

Accordingly, except with respect to a totally new subscriber installation, e.g., a new development or new portion of a development, or a "green field" project, advancing the fiber optic network all the way to the subscriber may not be easily accomplished, practical, or even possible. One reason is the existence of a legacy electrical telecommunication network infrastructure and investment, which cannot be discarded or disregarded, whether for economic, technical, or other reasons. In such cases, service providers are compelled to study ways to optimize the use of the legacy infrastructure to move the fiber optic network as close as possible to the subscriber premises. Typically, the legacy infrastructure includes electrical wiring buried in trenches; for instance, wiring over which plain old telephone service (POTS) communication was provided to the subscriber. The POTS network may involve twisted copper pair wiring that runs from the subscriber premises to some type of convergence point located a certain distance from the subscriber premises.

Service providers initially considered utilizing the existing telecommunication cabinets that provide a convergence location for the electrical telecommunication wiring of subscribers in a community or area, as the location to transition from optical to electrical communication service. This approach, referred to as a fiber-to-the-cabinet (FTTC) solution, was attractive to the service providers as the cabinets were already in existence, were suitably protected from the elements, and were provided with electrical power, which would be needed for the optical/electrical converters. These cabinets may have been located at points so as to converge a certain minimum number of subscribers at a maximum distance to support financial investment criteria for the electrical telecommunications network. Typically, the distance from the farthest subscriber to the cabinet may be several hundred meters or more. Although such distance does not affect the quality of voice transmission over electrical wiring, it does impact the transmission of data as bandwidth increases. So much so, that even relatively limited transmission distances have a major impact on the amount and speed of bandwidth that may be transmitted to the subscriber over an existing electrical telecommunication system. In this regard, a distance of several hundred meters can compromise the ability to provide current bandwidth needs of a subscriber, much less future needs. While the development of high bandwidth solutions for copper wiring, including, as examples, VDSL and G.fast, help with the bandwidth issue, even these protocols lose effectiveness over what would seem to be not that large of a distance. Because of this reality, service providers are beginning to accept that they cannot assume that a FTTC solution, in which they rely on advancing the fiber optic network to an existing centrally located service provider convergence cabinet, will provide sufficient bandwidth that subscribers require and demand, now and in the future.

Accordingly, service providers are now focusing on ways in which to advance the fiber optic network to a distribution point closer to the subscriber. This approach is referred as a fiber-to-the-distribution point (FTTdp) solution. The distribution point can be any existing location where communication hardware is already present, or a new location that does not currently have any communication hardware selected by the service provider. **In** either case, the distribution point may not provide a lot of space, or protection from the elements. The location may be outside, exposed to the elements and/or contamination. The location may be an existing "hand-hole" buried just beneath the surface, an existing telephone pole, or the surface of an outside wall of a structure, to name just a few. Accordingly, any fiber optic/electrical distribution device must be designed to withstand an environment that can present varied and extreme conditions. While being able to provide a sufficiently rugged fiber optic/electrical device does present issues to overcome, developing such a device that is able to dissipate any heat that may build up due to the active electronic components needed to convert the optical signals to electrical signals and the electrical signals to optical signals adds a significant level of complexity.

Consequently, there is an unresolved need for fiber optic/electrical distribution devices with optical/electrical signal conversion abilities positioned in a robust and hardened package that reliably performs in all different types of conditions and in various locations with respect to the subscriber.

No admission is made that any reference cited herein constitutes prior art. Applicant expressly reserves the right to challenge the accuracy and pertinence of any cited documents.

### SUMMARY

The problem is solved by the features of the independent claims. Advantageous embodiments are given by the dependent claims. The invention concerns a fiber optic/electrical distribution device according to claim 1 and a method of sealing a fiber optic/electrical distribution device according to claim 4.

Additional features and advantages will be set forth in the detailed description which follows, and in part will be readily apparent to those skilled in the art from the description or recognized by practicing the embodiments as described in the written description and claims hereof, as well as the appended drawings.

It is to be understood that both the foregoing general description and the following detailed description are merely exemplary, and are intended to provide an overview or framework to understand the nature and character of the claims.

The accompanying drawings are included to provide a further understanding, and are incorporated in and constitute a part of this specification. The drawings illustrate one or more embodiment(s), and together with the description serve to explain principles and operation of the various embodiments.

### BRIEF DESCRIPTION OF THE DRAWINGS

FIG. 1 is a diagram of an example communication network combining a fiber optic network extending from the central office to a distribution point having fiber optic/electrical distribution devices, and an electrical communication network extending from the distribution point to subscriber premises;
FIG. 2 is a diagrammatic, block representation of example electrical and optical connections to optical/electrical conversion and power conditioning components of a fiber optic/electrical distribution device;
FIG. 3 is an exploded top, perspective view of an exemplary fiber optic/electrical distribution device according to the present invention;
FIG. 4 is a partial, detail perspective view of the exemplary conversion assembly of FIG. 3;
FIG. 5 is a top, plan view of the fiber optic/electrical distribution device of FIG. 3 with a fiber optic cable and an electrical cable extended therefrom;
FIG. 6 is a bottom, plan view of the fiber optic/electrical distribution device of FIG. 3;
FIG. 7 is an exploded top, perspective view of an exemplary fiber optic/electrical distribution device according to the present invention;
FIG. 8 is a partial, detail perspective view of the exemplary conversion assembly of FIG. 7;
FIG. 9 is a top, plan view of the fiber optic/electrical distribution device of FIG. 7;
FIG. 10 is a bottom, plan view of the fiber optic/electrical distribution device of FIG. 7;
FIG. 11 is an exploded top, perspective view of an exemplary fiber optic/electrical distribution device; not according to the present invention.
FIG. 12 is a top, perspective view of the fiber optic/electrical distribution device of FIG. 11 with the conversion assembly withdrawn from the housing;
FIG. 13 is a rear, perspective view of the fiber optic/electrical distribution device of FIG. 11 with the second removable cover removed;
FIG. 14 is a partial, detail perspective view of an edge of the PCB in a PCB track of the guide track system in the housing of the fiber optic/electrical distribution device of FIG. 11;
FIG. 15 is a top, perspective view of the fiber optic/electrical distribution device of FIG. 11;
FIG. 16 is a partial, perspective view of an exemplary fiber optic/electrical distribution device, not according to the present invention;
FIG. 17 is a top, perspective view of an exemplary fiber optic/electrical distribution device, not according to the present invention; and
FIG. 18 is a flowchart diagram depicting the method of sealing a fiber optic/electrical distribution device.

### DETAILED DESCRIPTION

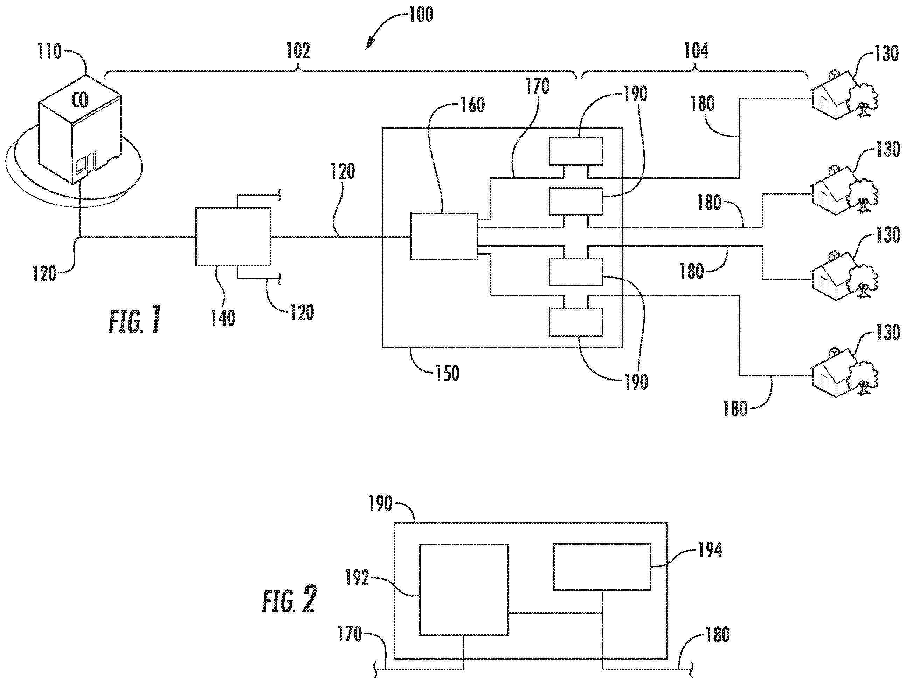

Referring now to FIG. 1, there is shown a simplified communication network 100 supporting a fiber-to-the-distribution-point (FTTdp) solution. A portion of the communication network 100 is a fiber optic communication network 102 and a portion is a legacy electrical communication network 104. The service provider provides optical communication service over the communication network 100 using the fiber optic communication network 102 from a central office 110 through distribution cabling 120 toward the user or subscriber at the subscriber premises 130. In this regard, the distribution cabling 120 extends from the central office 110 toward subscriber premises 130 utilizing intermediate distribution points or nodes 140. At a certain distribution point 150 in the communication network 100, proximal to the subscriber premises 130, the service provider converts from providing the communication service over a fiber optic communication network 102 to providing it over a legacy electrical communication network 104.

Although the communication service may properly be viewed as originating with the service provider at the central office 110, the actual flow of communication signals, (both optical and electrical) is bidirectional. In this way, optical and electrical communication signals may be both sent and received over the communication network 100. Although the optical and electrical signals travel in both directions, the perspective of the communication network 100 from the central office 110 toward the subscriber premises 130, is typically referred to as "downstream", while the perspective from the subscriber premises 130 back to the central office 110 is typically referred to as "upstream." In this regard, the terms "upstream" and "downstream" do not necessarily denote or control actual optical signal transmission direction, but refer to a relative physical direction in the communication network 100 that is either toward the subscriber premises 130 (downstream) or toward the central office 110 (upstream).

In FIG. 1, a distribution point 150 is shown located within a certain distance of one or more subscriber premises 130. This distance may be, for example, approximately 100 meters or less. The distribution point 150 may have fiber optic hardware 160, for example a multiport, for interconnecting fiber optic cable and/or for splitting an optical signal carried by the fiber optic cable into multiple optical signals for further distribution downstream. In FIG. 1, the fiber optic hardware 160 is shown as having four (4) outputs, which may relate to four (4) split optical signals carried by optical fibers 170 in each of the four (4) outputs. Distribution point 150 may also have one or more fiber optic/electrical distribution devices 190, which provide optical/electrical signal conversion. Four (4) fiber optic/electrical distribution devices 190 are shown in FIG. 1, each of which is connected to an output of the fiber optic hardware 160. In this regard, each fiber optic/electrical distribution device 190 may receive the optic signal carried by the optical fibers 170 and convert that optical signal to an electrical signal for transmission downstream to the subscriber premises 130 over electrical wiring 180. As discussed, both optical signals and the electrical signals in the communication network 100 are bi-directional. As such, it should be appreciated that the fiber optic/electrical distribution device 190 may also receive an electrical signal carried by electrical wiring 180 from the subscriber premises 130 and convert the electrical signal to an optical signal for transmission upstream toward the central office 110. Additionally, although FIG. 1 shows four (4) separate fiber optic/electrical distribution devices 190, space and cost consideration, particularly when considering the size of a hand hole, or the mounting space available on a telephone pole, as examples, may not allow for the installation of four (4), or even more than one (1), fiber optic/electrical distribution devices 190. In such case, a fiber optic/electrical distribution device 190 may be required to convert each optical signal into more than one (1) electrical signal, for example four (4) electrical signals, for transmission to the group of subscriber premises 130 shown in FIG.1.

Referring now to FIG. 2, a block diagram of portions of the active electronic components of the fiber optic/electrical distribution device 190 is illustrated. Although not shown in FIG. 2, the active components may be positioned on, and be part of, a conversion assembly including a printed circuit board (PCB). The conversion assembly will be discussed in more detail below. The active electronic components of the fiber optic/electrical distribution device 190 include an optical/electrical converter 192 and an electrical power circuit 194. The optical fiber 170 carrying the optical signal is in optical communication with the optical/electrical converter 192, either directly through a fiber optic cable that extends externally from the fiber optic/electrical distribution device 190, or through a connection with another fiber optic cable positioned in the fiber optic/electrical distribution device 190 already in optical communication with the optical/electrical converter 192. Also, the electrical wiring 180 carrying the electrical signal is in electrical contact with the optical/electrical converter 192, either directly through an electrical cable that extends externally from the fiber optic/electrical distribution device 190, or through a connection with another electrical conductor, such as for example, a trace on the PCB, already in electrical contact with the optical/electrical converter 192. Additionally, the electrical wiring 180 connects power from the subscriber premises 130 to operate the active components of the fiber optic/electrical distribution device 190.

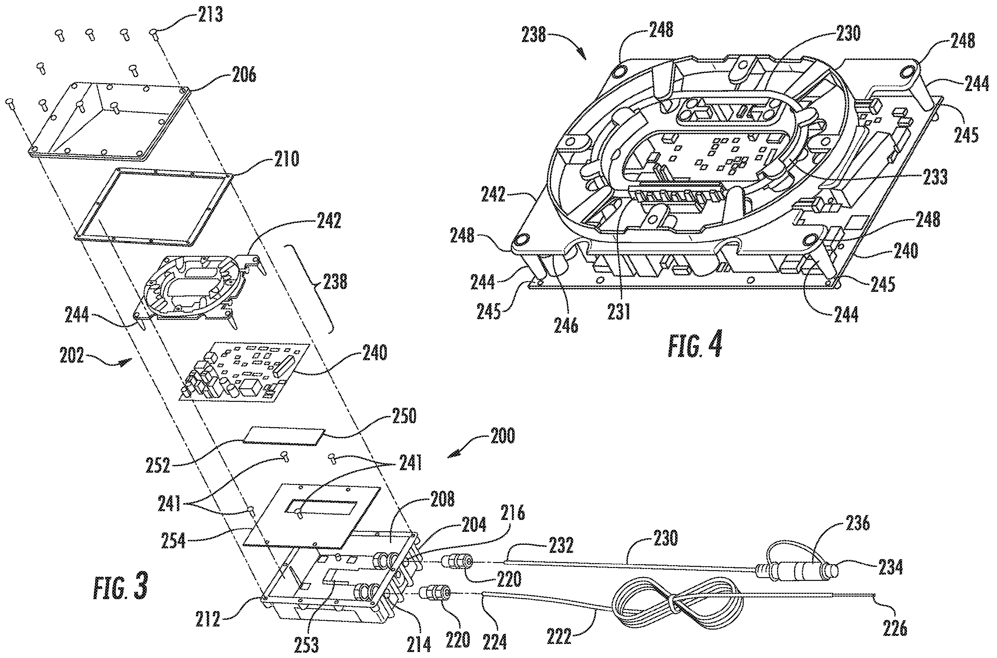

Turning to FIG. 3, there is shown a single port fiber optic/electrical distribution device 200, according to the present invention.. As discussed above, the fiber optic/electrical distribution device 200 may be positioned in or at a distribution point located in an area subject to extreme weather, temperature or physical conditions or exposed to certain environmental contamination from which the distribution point, a hand hole for example, may not be able to protect the fiber optic/electrical distribution device 200. Accordingly, the fiber optic/electrical distribution device 200 may include a housing 202 having a base 204 and a removable cover 206, defining an interior volume 208. The housing 202, which may be of a metal or partially metal construction, and e-coated with a corrosion resistant solution, or, alternatively, a plastic or other non-metal material, may be suitably ruggedized and sealed with a sealing element 210 positioned at an interface 212 of the base 204 and the removable cover 206. As examples, the sealing element 210 may be a gasket or an O-ring, or other component or material suitable for protecting the interior volume 208 and its contents from any environmental effects or contamination. The removable cover 206 may attach to the base 204 using any suitable fasteners 213, such as, for examples screws or the like. The fasteners 213 may fasten the removable cover 206 and the sealing element 210 to the base 204 at the interface 212.

As used herein, the term single port refers to the number of electrical cable ports 214 of the fiber optic/electrical distribution device 200. In FIG. 3, the fiber optic/electrical distribution device 200 is shown as having one electrical cable port 214. The electrical cable port 214 extends into the interior volume 208 and is accessible externally from the housing 202. Since it extends into the interior volume 208, the electrical cable port 214 is sealed to prevent ingress of dust and water into the interior volume 208. Similarly, a fiber optic cable port 216 extends into the interior volume 208 and is accessible externally from the housing 202. As with the electrical cable port 214, since the fiber optic cable port 216 extends into the interior volume 208, the fiber optic cable port 216 is sealed to prevent ingress of dust and water into the interior volume 208. As shown in FIG. 3, compression fittings 220 may be used to seal the electrical cable port 214 and fiber optic cable port 216.

In FIG. 3, an electrical cable 222, having a first end 224 and a second end 226 passes through the electrical cable port 214 and the compression fitting 220 therein. The first end 224 of the electrical cable 222 locates in the interior volume 208, while the second end 226 of the electrical cable 222 locates outside of the interior volume 208. The electrical cable 222 may be an electrical cable pigtail with an electrical connector (not shown on FIG. 2) attached to the second end 226. Additionally, a fiber optic cable 230, having a first end 232 and a second end 234, passes through the fiber optic cable port 216 and the compression fitting 220 therein. The first end 232 of the fiber optic cable 230 locates in the interior volume 208, while the second end 234 of the fiber optic cable 230 locates outside of the interior volume 208. The fiber optic cable 230 may be a fiber optic pigtail with a hardened connector 236 attached to the second end 234.

Referring also now to FIG. 4 in addition to FIG. 3, a conversion assembly 238 may be positioned in the interior volume 208 of the housing 202. The conversion assembly 238 includes a PCB 240 and fiber optic cable tray 242 supported in stacked alignment with the PCB 240. The PCB 240 may be attached to the housing 202 using any suitable fasteners 241, such as, for example screws or the like. As shown with particular reference to FIG. 4, the fiber optic cable tray 242 has four (4) stand-offs 244 extending from its surface 246. In FIG. 4, three (3) of the four (4) stand-offs 244 are shown extending from the surface 246 at corners 248 of the fiber optic cable tray 242. The stand-offs 244 position in receiving holes 245 in the PCB 240 and extend for a certain distance above the surface of the PCB 240 to maintain a defined spacing between the fiber optic cable tray 242 and the PCB 240 to allow clearance for the components mounted on the PCB 240 and to facilitate dissipation of any heat produced by any of the components mounted on the PCB 240. The stand-offs 244 not only maintain spacing between the PCB 240 and the fiber optic cable tray 242, but, also, maintain the PCB 240 and the fiber optic cable tray 242 in appropriate lateral alignment. The PCB 240 and the fiber optic cable tray 242, shown in FIGS. 3 and 4, are approximately the same size, i.e., their respective footprints may be coextensive. The PCB 240 and the fiber optic cable tray 242 maintain such space and alignment as the conversion assembly 238 is positioned in the housing 202. Additionally, when the removable cover 206 is attached to the base 204, the fiber optic cable tray 242 is sandwiched between the removable cover 206 and the PCB 240, securing the fiber optic cable tray 242 in the housing 202 and, thereby, further maintaining the spacing and alignment of the fiber optic cable tray 242 with the PCB 240.

The fiber optic cable tray 242 may be used to manage and store fiber optic cable 230 that is extended into the housing 202 and provide a platform for any connection 231 between the fiber optic cable 230 extended through the fiber optic cable port 216 and fiber optic cable 233 in optical communication with the optical/electrical converter (see FIG. 2). The connection 231 may be in the form of a fusion splice or a mechanical connection.

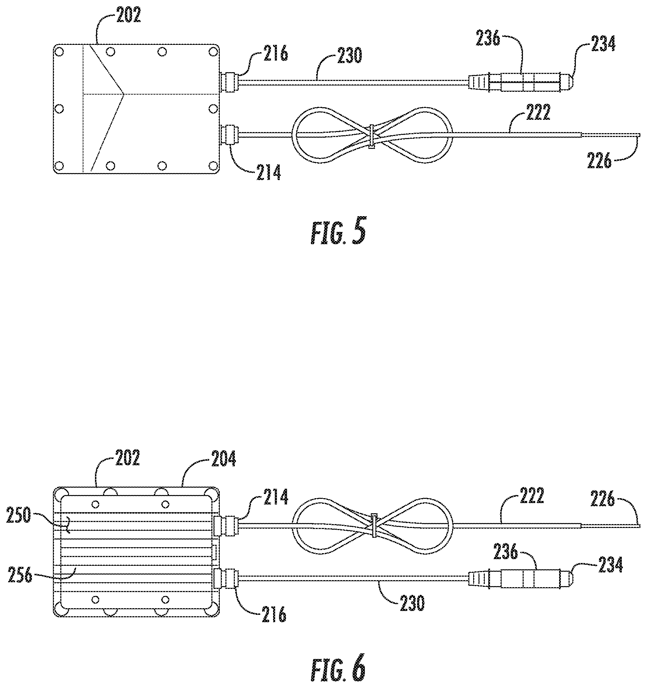

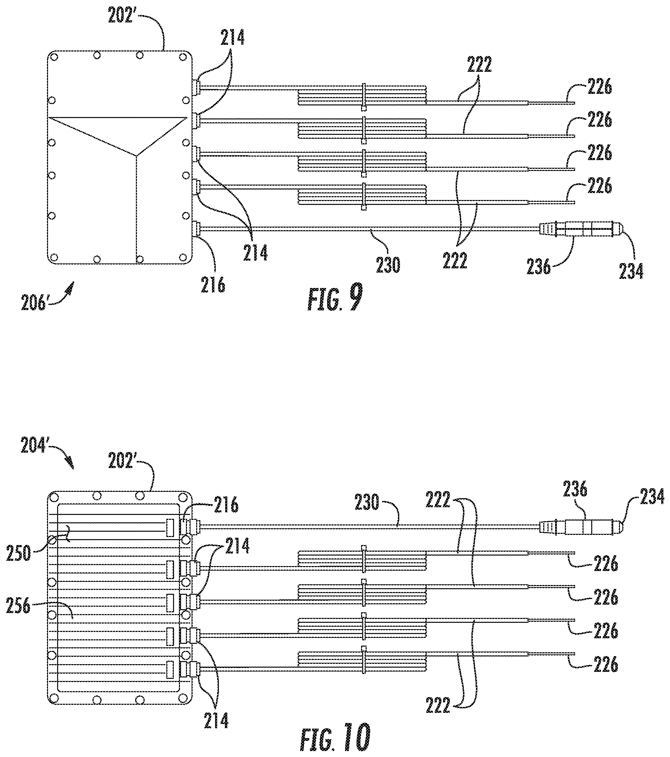

Referring now primarily to FIG. 3, a heat dissipation component 250 positions in the housing 202 in such a way as to be in thermal transference with the conversion assembly 238, and particularly, the PCB 240. In FIG. 3, the heat dissipation component 250 is shown as a thermal pad 252 that may be positioned with a raised pedestal 253 located on the base 204 of the housing 202. A mylar film 254 may be included in the interior volume 208 of the housing 202 to inhibit electrostatic discharge between the PCB 240 and the housing 202. The thermal pad 252 may be any suitable thermally conductive product, such as for example a product constructed of highly conformable and low modulus, thermally conductive material for use with electronic components. Other heat dissipation components 250 may be used, including, without limitation, heat sink structures, as will be discussed with reference to FIGS. 6 and 10.

In FIGS. 5 and 6, there are shown a top plan view and a bottom plan view, respectively, of the fiber optic/electrical distribution device 200. The electrical cable 222 may extend from the housing 202 at the electrical cable port 214 to the second end 226. The fiber optic cable 230 may extend from the housing 202 at the fiber optic cable port 216 to the second end 234 and have a hardened connector 236 attached to the second end 234. The hardened connector may be an OptiTap^{®} as provided by Corning Optical Communications LLC of Hickory, NC. In FIG. 5, the removable cover 206 is shown attached to the base 204 (see FIG. 6) of the housing 202. In FIG. 6, the base 204 is shown as having a heat dissipation component 250 in the form of heat sink structures 256 extending from the surface of the base 204. As discussed with respect to FIG. 3, the thermal pad 252 may be positioned on a raised pedestal 253 and the mylar film 254 may be included to inhibit electrostatic discharge between the PCB 240 and the housing 202. The heat sink structures 256, provide a thermal transference for dissipating heat that may build up from the components mounted on the PCB 240.

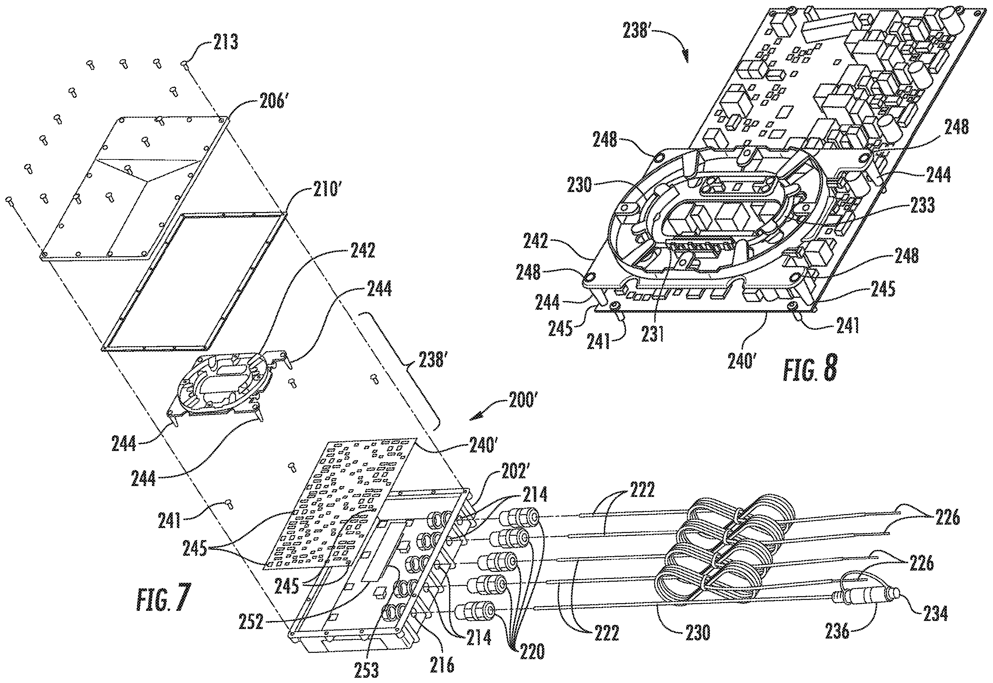

Referring now to FIGS. 7-10, there is shown an exemplary embodiment of a four port fiber optic/electrical distribution device 200' according to the present invention. As discussed above with reference to "single port" in FIG. 3, the term "four port" refers to the number of electrical cable ports 214 of the fiber optic/electrical distribution device 200'. The description of the fiber optic/electrical distribution device 200' having four electrical cable ports 214 is the same as the description for fiber optic/electrical distribution device 200, except with respect to the number of electrical cable ports 214 and electrical cables 222 extending from the housing 202'. Therefore, except for any substantive differences associated with having four electrical ports 214 instead of one electrical port 214, the discussion of the four port fiber optic/electrical distribution device 200' which is similar to the discussion of the single port fiber optic/electrical distribution device 200 will not be repeated here with respect to FIGS. 7-10.

One difference, though, is the size of the housing 202'. The housing 202' is shown in FIGS. 7-10 as being sized to accommodate the increased number of electrical cable ports 214. Additionally, the PCB 240' may be expanded in accordance with the requirement to convert one optical signal into four (4) electrical signals. However, although there are three (3) additional electrical cable ports 214 and electrical cables 222, there is one fiber optic cable port 216 receiving one fiber optic cable 230, as with fiber optic/electrical distribution device 200. As such, the fiber optic cable tray 242 may retain the same size as used in the fiber optic/electrical distribution device 200. In this regard, with reference to FIG. 8, a conversion assembly 238' has PCB 240' with a fiber optic cable tray 242 shown supported in stacked alignment with the PCB 240'. The fiber optic cable tray 242 has four (4) stand-offs 244 shown extending from the surface 246 at corners 248 of the fiber optic cable tray 242. The stand-offs 244 position in receiver holes 245 on the PCB 240'. Since the PCB 240' is larger than the fiber optic cable tray 242, they do not have the same platform size; their respective footprints may not be coextensive. As with the discussion involving FIG. 4, the stand-offs 244 may provide sufficient spacing between the fiber optic cable tray 242 and the PCB 240' to allow clearance for the components mounted on the PCB 240' and to promote dissipation of any heat produced by any of the components mounted on the PCB 240'. The stand-offs 244 maintain such spacing even as the conversion assembly 238' is positioned in the housing 202'.

In FIG. 9, the removable cover 206' is shown attached to the base 204' (see FIG. 10) of the housing 202'. In FIG. 10, the base 204' is shown as having a heat dissipation component 250 in the form of heat sink structures 256 extending from the surface of the base 204'. As shown in FIG. 7 when discussing fiber optic/electrical distribution device 200, the thermal pad 252 is positioned on a pedestal 253 in the housing 202'. The heat sink structures 256, thereby, provide a thermal transference for dissipating heat that may build up from the components mounted on the PCB 240'.

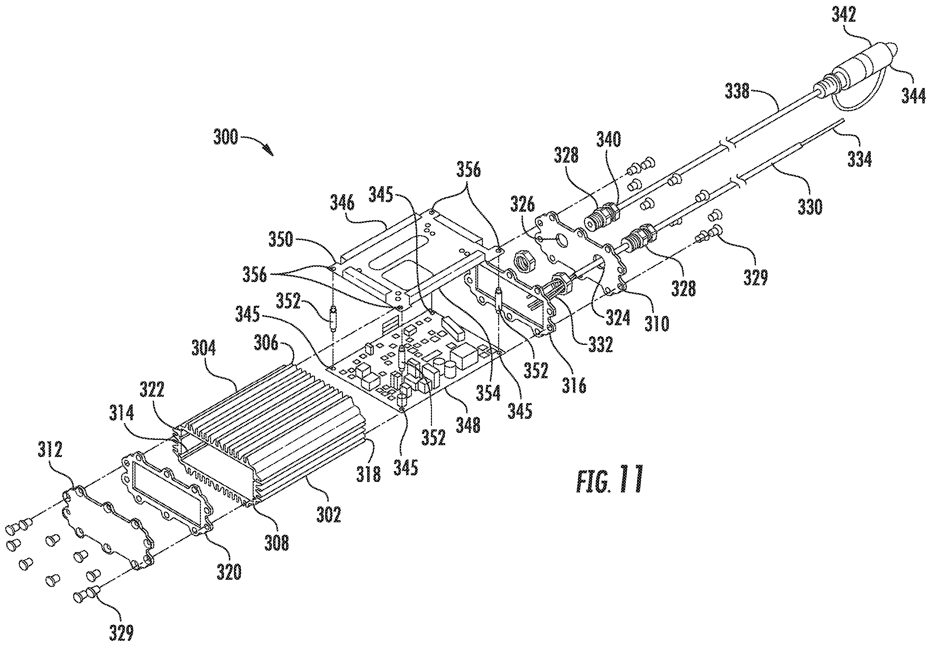

FIG. 11 illustrates an exemplary embodiment of a fiber optic/electrical distribution device 300, which is not according to the present invention. Fiber optic/electrical distribution device 300 has a housing 302 having a base 304 which may be open at opposing first end 306 and second end 308, a first removable cover 310 may attach to the base 304 at the first end 306, while a second removable cover 312 may attach to the base 304 at the second end 308. The housing 302 defines an interior volume 314, and may be constructed of extruded aluminum. The housing 302 may be sealed with a first sealing element 316 positioned at an interface 318 of the base 304 and the first removable cover 310. A second sealing element 320 may be positioned at an interface 322 of the base 304 and the second removable cover 312. As examples, the first sealing element 316 and the second sealing element 320 may be a gasket or an O-ring, or other component or material suitable for protecting the interior volume 314 and its contents from any environmental effects. The first removable cover 310 and second removable cover 312 may be attached to the base 304 using any suitable fasteners 329, such as, for example screws or the like. The fasteners 329 may fasten the first removable cover 310 and the first sealing element 316 to the base 304 at interface 318, as well as the second removable cover 312 and the second sealing element 320 to the base 304 at interface 322.

In FIG. 11, the fiber optic/electrical distribution device 300 is shown as having one electrical cable port 324. The electrical cable port 324 extends into the interior volume 314 through the first removable cover 310 and is accessible externally from the housing 302. Since electrical cable port 324 extends into the interior volume 314, the electrical cable port 324 is sealed to prevent ingress of dust and water into the interior volume 314. Similarly a fiber optic cable port 326 extends into the interior volume 314 through first removable cover 310 and is accessible externally from the housing 302. As with the electrical cable port 324, since the fiber optic cable port 326 extends into the interior volume 314 of the housing 302, the fiber optic cable port 326 is sealed to prevent ingress of dust and water into the interior volume 314. As shown in FIG. 11, compression fittings 328 may be used to seal the electrical cable port 324 and fiber optic cable port 326.

With continued reference to FIG. 11, an electrical cable 330, having a first end 332 and a second end 334 passes through the electrical cable port 324 and the compression fitting 328 therein. The first end 332 of the electrical cable 330 locates in the interior volume 314, while the second end 334 of the electrical cable 330 locates outside of the interior volume 314. The electrical cable 330 may be an electrical cable pigtail with an electrical connector (not shown on FIG. 11) attached to the second end 334. Additionally, a fiber optic cable 338, having a first end 340 and a second end 342 passes through the fiber optic cable port 326 and the compression fitting 328 therein. The first end 340 of the fiber optic cable 338 locates in the interior volume 314 while the second end 342 of the fiber optic cable 338 locates outside of the interior volume 314. The fiber optic cable 338 may be a fiber optic pigtail with a hardened connector 344 attached to the second end 342.

A conversion assembly 346 may be positionable in the interior volume 314 of the housing 302. The conversion assembly 346 includes a PCB 348 and fiber optic cable tray 350 supported in stacked alignment with the PCB 348. The fiber optic cable tray 350 has four (4) stand-offs 352 extending from its surface 354. In FIG. 11, three (3) of the four (4) stand-offs 352 are shown extending from the surface 354 at corners 356 of the fiber optic cable tray 350. The stand-offs 352 position in receiving holes 345 in the PCB 348 and extend for a certain distance above the surface of the PCB 348 to maintain a defined spacing between the fiber optic cable tray 350 and the PCB 348 to provide sufficient space between the fiber optic cable tray 350 and the PCB 348 to allow clearance for the components mounted on the PCB 348 and promote dissipation of any heat produced by any of the components mounted on the PCB 348.

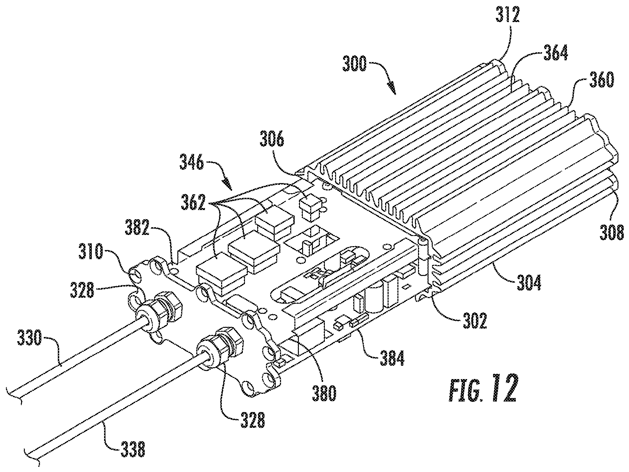

The conversion assembly 346 attaches to the first removable cover 310 such that when the first removable cover 310 is disconnected from the base 304, the first removable cover 310 may be used to withdraw the conversion assembly 346, the electrical cable 330 and the fiber optic cable 338 from the interior volume 314, extending them out of and separating them from the housing 302. FIG. 12 illustrates the first removable cover 310, the conversion assembly 346, the electrical cable 330 and the fiber optic cable 338 extended from the housing 302. The electrical cable 330 and the fiber optic cable 338 remain attached to the first removable cover 310 due to the compression fittings 328. In this way, the first removable cover 310, the conversion assembly 346, the electrical cable 330, and the fiber optic cable 338 may extend from the housing 302 as a single assembly at and through the first end 306 of the base 304. The second removable cover 312 remains attached to the second end 308 of the base 304.

Heat dissipation components 360 may include thermal pads 362 and heat sink structure 364. Four thermal pads 362 are shown extending from the PCB 348 through the fiber optic cable tray 350. The thermal pads 362 extend through the fiber optic cable tray 350 to the heat producing components on the PCB 348. Additionally, a heat sink structure 364 may extend from the base 304 of the housing 302, which provides for the outside of the housing 302 to be a heat dissipation component 360. In this way, the thermal pads 362 and heat sink structure 364 provide a thermal transference of heat away from the conversion assembly 346, especially the PCB 348.

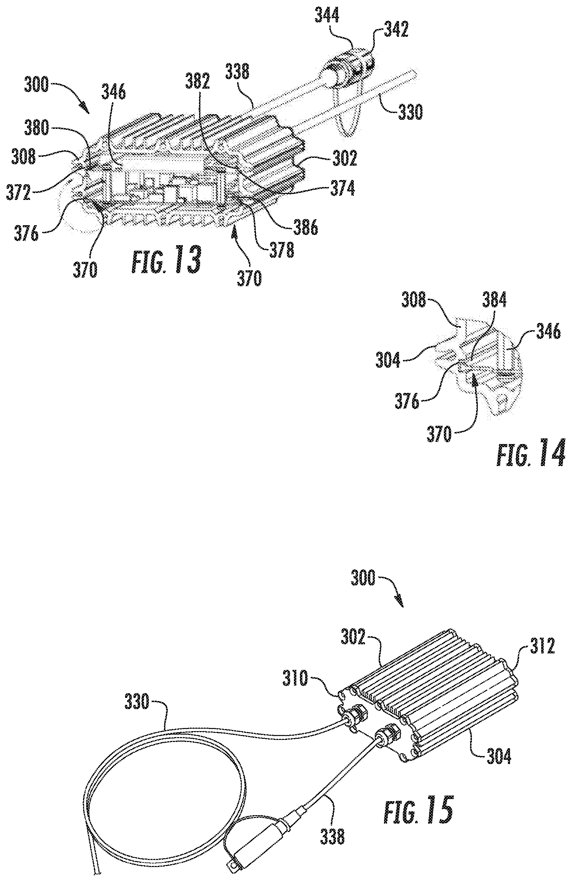

Referring now to FIGS. 13 and 14, in addition to FIG. 12, a guide system 370 is shown attached to the housing 302 in the interior volume 314. The guide system 370 includes a first tray track 372 and a second tray track 374 used to guide the fiber optic cable tray 350 into and out of the housing 302. The guide system 370 also includes a first PCB track 376 and a second PCB track 378 used to guide the PCB 348 into and out of the housing 302. In this regard, as the first removable cover 310 is used to withdraw the conversion assembly 346 from the housing 302, a first tray edge 380 movably slides in the first tray track 372 and a second tray edge 382 movably slides in the second tray track 374. In a similar manner, a first PCB edge 384 movably slides in the first PCB track 376 and a second PCB edge 386 movably slides in the second PCB track 378. Since the first tray track 372, second tray track 374, first PCB track 376, and second PCB track 378 are fixed with the housing 302, the guide system 370 may also serve to maintain the spacing and lateral alignment between the PCB 348 and fiber optic cable tray 350.

In FIG. 15, a fully assembled fiber optic/electrical distribution device 300 is shown. The first removable cover 310 and the second removable cover 312 are attached to the base 304 of the housing 302. An electrical cable 330 and a fiber optic cable 338 extend from the housing 302 through the first removable cover 310.

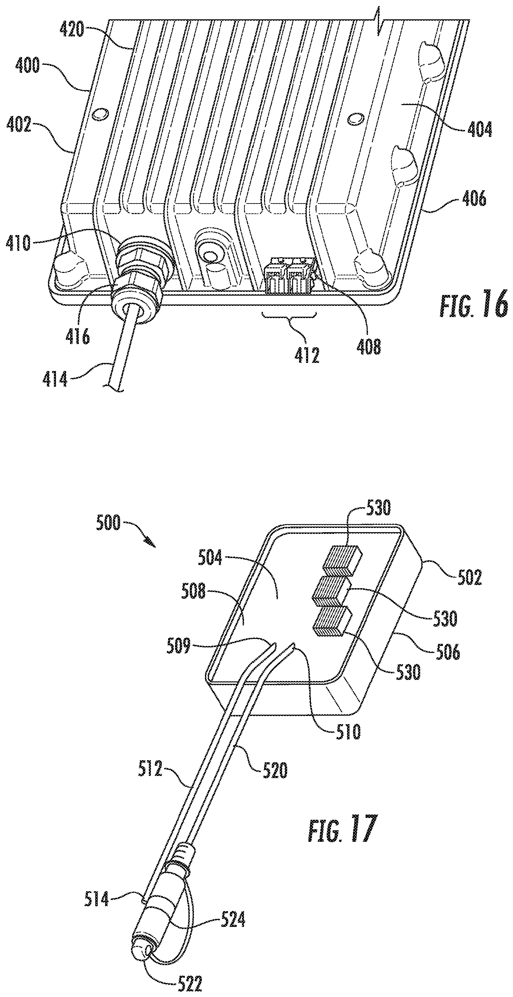

FIG. 16 illustrates another example of fiber optic/electrical distribution device 400, not forming a part of the present invention. The fiber optic/electrical distribution device 400 has a housing 402 with a base 404 and a cover 406. An electrical cable port 408 and a fiber optic cable port 410 extend from the base 404. However, although the fiber optic cable port 410 is shown as similar to the fiber optic cable ports shown and discussed previously including with a compression fitting 416, the electrical cable port 408 shown in FIG. 16 has a different form. In FIG. 16, the electrical cable port 408 includes a pair of insulation displacement contacts (IDC) 412. Although not shown, the IDCs 412 are electrically connected to the optical/electrical converter and other active components of the fiber optic/electrical distribution device 400 in the housing 402. In this way, the electrical wiring from the subscriber premises can be connected by attaching them to the IDC on the outside of the housing 402. A fiber optic cable 414 attaches to the housing 402 in the manner described previously. Fiber optic/electrical distribution device 400 is shown as having a heat sink structure 420 extending from the base 404 to provide thermal transference from the housing 402.

FIG. 17 depicts another example of a fiber optic/electrical distribution device 500, not forming a part of the present invention. In FIG. 17, the fiber optic/electrical distribution device 500 is shown having a housing 502 with an interior volume 504 and a coverless base 506. Potting material 508 is disposed in the housing 502 into the interior volume 504. Electrical cable port 509 and fiber optic cable port 510 are formed by an electrical cable 512 and a fiber optic cable 520, respectively, at the point where they extend out of the potting material 508. Although not shown in FIG. 17, the electrical cable 512 was connected to the optical/electrical converter and other active components prior to the potting material 508 being disposed in the interior volume 504 over the conversion assembly in the housing 502. Similarly, the fiber optic cable 520 was connected, either directly or indirectly through another cable, to the optical/electrical converter positioned in the interior volume 504 prior to the potting material 508 being disposed in the interior volume 504 over the conversion assembly in the housing 502. An end 514 of the electrical cable 512 extends externally of the housing 502. Also, an end 522 of the fiber optic cable 520 extends externally from the housing 502 and has a hardened fiber optic connector 524 attached to it. Three thermal transfer pads 530 also extend from the potting material 508 to provide heat dissipation from the active components in the housing 502.

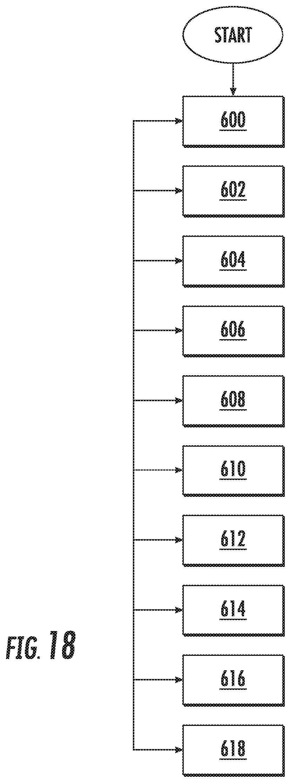

FIG. 18 depicts a method of sealing a fiber optic/electrical distribution device 200, 200', 300. The method may be implemented by extending the electrical cable port 214, 324 into the interior volume 208, 314 of the housing 202, 202', 302, the electrical cable port 214, 324 being accessible externally from the housing 202, 202', 302 (block 600 in FIG. 18); sealing the electrical cable port 214, 324 to prevent ingress of dust and water into the interior volume 208, 314 (block 602 in FIG. 18); extending a fiber optic cable port 216, 326 into the interior volume 208, 314 of the housing 202, 202', 300, the fiber optic cable port 216, 326 being accessible externally from the housing 202, 202', 300 (block 604 in FIG. 18); sealing the fiber optic cable port 216, 326 to prevent ingress of dust and water into the interior volume 208, 314 (block 606 in FIG. 18); positioning a conversion assembly 238, 238', 346 in the interior volume 208, 314 the conversion assembly 238, 238', 346 having a PCB 240, 240', 348 and a fiber optic cable tray 242, 350, the PCB 240, 240', 348 having an optical/electrical converter 192 (see FIG. 2) and an electrical power circuit 194 (see FIG. 2), with the fiber optic cable tray 242, 350 supported in stacked alignment with the PCB 240 240', 348 (block 608 in FIG. 18); sealing the interior volume 208, 314 from environmental effects; maintaining a defined spacing between the PCB 240, 240', 348 and the fiber optic cable tray 242, 350 (block 610 in FIG. 18); maintaining the PCB 240, 240', 348 and the fiber optic cable tray 242, 350 in lateral alignment (block 612 in FIG. 18); extending a plurality of stand-offs 244, 352 from the surface of the fiber optic equipment tray 242, 350 (block 614 in FIG. 18); positioning ones of the plurality of stand-offs 244, 352 in respective ones of the plurality of receiving holes 245, 345 in the PCB 240, 240', 348 (block 616 in FIG. 18); and e-coating the housing 202, 202', 302 with corrosion resistant solution (block 618 in FIG. 18).

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that any particular order be inferred.

It will be apparent to those skilled in the art that various modifications and variations can be made without departing from the invention as defined by the attached claims. Since modifications combinations, sub-combinations and variations of the disclosed embodiments of the invention may occur to persons skilled in the art, the invention should be construed to include everything within the scope of the appended claims.

## Claims

1. A fiber optic/electrical distribution device (190, 200, 200', 300, 400, 500), comprising:
a housing (202, 202', 302, 402, 502) defining an interior volume (208, 314, 504);
an electrical cable port (214, 324, 408, 509) extended into the interior volume (208, 314, 504) and accessible externally from the housing (202, 202', 302, 402, 502), wherein the electrical cable port (214, 324, 408, 509) is sealed to prevent ingress of dust and water into the interior volume (208, 314, 504);
a fiber optic cable port (216, 326, 410, 510) extended into the interior volume (208, 314, 504) and accessible externally from the housing (202, 202', 302, 402, 502), wherein the fiber optic cable port (216, 326, 410, 510) is sealed to prevent ingress of dust and water into the interior volume (208, 314, 504); and
a conversion assembly (238, 238', 346) positioned in the interior volume (208, 314, 504), wherein the conversion assembly (238, 238', 346) comprises:
a printed circuit board, PCB, (240, 240', 348) comprising an electrical power circuit (194);
a fiber optic cable tray (242, 350) supported in stacked alignment with the PCB (240, 240', 348);
wherein a defined spacing is maintained between the PCB (240, 240', 348) and the fiber optic cable tray (242, 350), and wherein the PCB (240, 240', 348) and the fiber optic cable tray (242, 350) are maintained in lateral alignment;
wherein the housing (202, 202', 302, 402, 502) comprises a base (204, 204', 304, 404), **characterized in that** the fiber optic/electrical distribution device (190, 200, 200', 300, 400, 500) comprises
- the printed circuit board, PCB, (240, 240', 348) comprising an optical/electrical converter (192)
and the housing (202, 202', 302, 402, 502) comprises a removable cover (206, 206', 310, 312) attached to the base (204, 204', 348); and
- wherein the fiber optic cable tray (242, 350) is sandwiched between the removable cover (206, 206', 310, 312) and the PCB (240, 240', 348), maintaining the defined spacing and the lateral alignment of the fiber optic cable tray (242, 350) with the PCB (240, 240', 348), and
wherein the fiber optic/electrical distribution device (190, 200, 200', 300, 400, 500) further comprises a sealing element (210, 316, 320) positioned at an interface (212, 318, 322) between the removable cover (206, 206', 310, 312) and the base (204, 204', 304, 404),
wherein the fiber optic/electrical distribution device (190, 200, 200', 300, 400, 500) further comprises a plurality of stand-offs (244, 352) extending from a surface (246, 354) of the fiber optic cable tray (242, 350).

2. The fiber optic/electrical distribution device (190, 200, 200', 300, 400, 500) of claim 1, wherein the conversion assembly (238, 238', 346) is positionable into and out of the interior volume (208, 314, 504).

3. The fiber optic/electrical distribution device (190, 200, 200', 300, 400, 500) of any of claims 1-2, further comprising a heat dissipation component (250, 360), wherein the heat dissipation component (250, 360) is in thermal transference with the conversion assembly (238, 346).

4. A method of sealing a fiber optic/electrical distribution device (190, 200, 200', 300, 400, 500), comprising:
extending an electrical cable port (214, 324, 408, 509) into an interior volume (208, 314, 504) of a housing (202, 202', 302, 402, 502), wherein the electrical cable port (214, 324, 408, 509) is accessible externally from the housing (202, 202', 302, 402, 502);
sealing the electrical cable port (214, 324, 408, 509) to prevent ingress of dust and water into the interior volume (208, 314, 504);
extending a fiber optic cable port (216, 326, 410, 510) into the interior volume (208, 314, 504) of the housing (202, 202', 302, 402, 502), wherein the fiber optic cable port (216, 326, 410, 510) is accessible externally from the housing (202, 202', 302, 402, 502);
sealing the fiber optic cable port (216, 326, 410, 510) to prevent ingress of dust and water into the interior volume (208, 314, 504);
positioning a conversion assembly (238, 238', 346) in the interior volume (208, 314, 504), wherein the conversion assembly (238, 238', 346) comprises:
a printed circuit board, PCB, (240, 240', 348) comprising an electrical power circuit (194); and
a fiber optic cable tray (242, 350) supported in stacked alignment with the PCB (240, 240', 348);
sealing the interior from environmental effects;
maintaining a defined spacing between the PCB (240, 240', 348) and the fiber optic cable tray (242, 350); and
maintaining the PCB (240, 240', 348) and the fiber optic cable tray (242, 350) in lateral alignment wherein the housing (202, 202', 302, 402, 502) comprises a base (204, 204', 304, 404) ), **characterized in that**
- the printed circuit board, PCB, (240, 240', 348) comprises an optical/electrical converter (192) and
- the housing (202, 202', 302, 402, 502) comprises a removable cover (206, 206', 310, 312) attached to the base (204, 204', 348),
- wherein the conversion assembly (238, 238', 346) is positioned in the interior volume (208, 314, 504) such that the fiber optic cable tray (242, 350) is sandwiched between the removable cover (206, 206', 310, 312) and the PCB (240, 240', 348), maintaining the defined spacing and the lateral alignment of the fiber optic cable tray (242, 350) with the PCB (240, 240', 348), and
wherein a sealing element (210, 316, 320) is positioned at an interface (212, 318, 322) between the removable cover (206, 206', 310, 312) and the base (204, 204', 304, 404), and wherein the method further comprises extending a plurality of stand-offs (244, 352) from a surface (246, 354) of the fiber optic cable tray (242, 350).

5. The method of claim 4, wherein the PCB (240, 240', 348) comprises a plurality of receiving holes (245, 345), and further comprising positioning ones of the plurality of stand-offs (244, 352) in respective ones of the plurality of receiving holes (245, 345).

6. The method of any of claims 4 to 5, wherein the electrical cable port (214, 324, 408, 509) comprises a compression fitting (220, 328, 416), and wherein the fiber optic cable port (216, 326, 410, 510) comprises a compression fitting (220, 328, 416).

7. The method of any of claims 4 to 6, further comprising e-coating the housing (202, 202', 302, 402, 502) with corrosion resistant solution.

## Patentansprüche

1. Glasfaser-/Stromverteilungsvorrichtung (190, 200, 200', 300, 400, 500), umfassend:
ein Gehäuse (202, 202', 302, 402, 502), das einen Innenraum (208, 314, 504) begrenzt;
einen elektrischen Kabelanschluss (214, 324, 408, 509), der sich in den Innenraum (208, 314, 504) erstreckt und von außen über das Gehäuse (202, 202', 302, 402, 502) zugänglich ist, wobei der elektrische Kabelanschluss (214, 324, 408, 509) abgedichtet ist, um das Eindringen von Staub und Wasser in den Innenraum (208, 314, 504) zu verhindern;
eine Glasfaserkabelöffnung (216, 326, 410, 510), die sich in den Innenraum (208, 314, 504) erstreckt und von außen über das Gehäuse (202, 202', 302, 402, 502) von außen zugänglich ist, wobei der Glasfaserkabelanschluss (216, 326, 410, 510) abgedichtet ist, um das Eindringen von Staub und Wasser in den Innenraum (208, 314, 504) zu verhindern; sowie
eine im Innenraum (208, 314, 504) angeordnete Umwandlungsbaugruppe (238, 238', 346), wobei die Umwandlungsbaugruppe (238, 238', 346) umfasst:
eine Leiterplatte (PCB) (240, 240', 348), die eine Stromversorgungsschaltung (194) umfasst;
eine Glasfaserkabelrinne (242, 350), die gestapelt und fluchtend zur Leiterplatte (PCB) (240, 240', 348) angeordnet ist;
wobei ein definierter Abstand zwischen der Leiterplatte (240, 240', 348) und der Glasfaserkabelwanne (242, 350) eingehalten wird und wobei die Leiterplatte (240, 240', 348) und die Glasfaserkabelwanne (242, 350) in seitlicher Ausrichtung gehalten werden;
wobei das Gehäuse (202, 202', 302, 402, 502) einen Sockel (204, 204', 304, 404) umfasst, **dadurch gekennzeichnet, dass** die Glasfaser-/elektrische Verteilervorrichtung (190, 200, 200', 300, 400, 500) Folgendes umfasst:
- die Leiterplatte (PCB) (240, 240', 348) mit einem optischen/elektrischen Wandler (192)
und das Gehäuse (202, 202', 302, 402, 502) eine abnehmbare Abdeckung (206, 206', 310, 312) umfasst, die an der Basis (204, 204', 348) befestigt ist; und
- wobei die Glasfaserkabelrinne (242, 350) zwischen der abnehmbaren Abdeckung (206, 206', 310, 312) und der Leiterplatte (240, 240', 348) angeordnet ist, wodurch der definierte Abstand und die seitliche Ausrichtung der Glasfaserkabelrinne (242, 350) zur Leiterplatte (240, 240', 348) gewährleistet, und
wobei die Glasfaser-/Stromverteilungsvorrichtung (190, 200, 200', 300, 400, 500) ferner ein Dichtungselement (210, 316, 320) umfasst, das an einer Schnittstelle (212, 318, 322) zwischen der abnehmbaren Abdeckung (206, 206', 310, 312) und dem Sockel (204, 204', 304, 404) angeordnet ist,
wobei die Glasfaser-/Stromverteilungsvorrichtung (190, 200, 200', 300, 400, 500) ferner eine Vielzahl von Abstandshaltern (244, 352) umfasst, die sich von einer Oberfläche (246, 354) der Glasfaserkabelrinne (242, 350) erstrecken.

2. Glasfaser-/Stromverteilungsvorrichtung (190, 200, 200', 300, 400, 500) nach Anspruch 1, wobei die Umwandlungsbaugruppe (238, 238', 346) in den Innenraum (208, 314, 504) hinein- und aus diesem heraus positionierbar ist.

3. Glasfaser-/Stromverteilungsvorrichtung (190, 200, 200', 300, 400, 500) nach einem der Ansprüche 1 bis 2, die ferner eine Wärmeableitungskomponente (250, 360) umfasst, wobei die Wärmeableitungskomponente (250, 360) in thermischem Kontakt mit der Umwandlungsbaugruppe (238, 346) steht.

4. Verfahren zum Abdichten einer Glasfaser-/Stromverteilungsvorrichtung (190, 200, 200', 300, 400, 500), umfassend:
Einführen einer elektrischen Kabelöffnung (214, 324, 408, 509) in einen Innenraum (208, 314, 504) eines Gehäuses (202, 202', 302, 402, 502), wobei die elektrische Kabelöffnung (214, 324, 408, 509) von außen auf das Gehäuse (202, 202', 302, 402, 502) zugänglich ist;
Abdichten der elektrischen Kabelöffnung (214, 324, 408, 509), um das Eindringen von Staub und Wasser in den Innenraum (208, 314, 504) zu verhindern;
Einführen eine Glasfaserkabelöffnung (216, 326, 410, 510) in den Innenraum (208, 314, 504) des Gehäuses (202, 202', 302, 402, 502), wobei die Glasfaserkabelöffnung (216, 326, 410, 510) von außen auf das Gehäuse (202, 202', 302, 402, 502) zugängliche ist;
Abdichten der Glasfaserkabelöffnung (216, 326, 410, 510), um das Eindringen von Staub und Wasser in den Innenraum (208, 314, 504) zu verhindern;
Anordnen einer Umwandlungsbaugruppe (238, 238', 346) im Innenraum (208, 314, 504), wobei die Umwandlungsbaugruppe (238, 238', 346) umfasst:
eine Leiterplatte (PCB) (240, 240', 348), die einen Stromversorgungsschaltkreis (194) umfasst; und
eine Glasfaserkabelrinne (242, 350), die gestapelt und fluchtend zur Leiterplatte (PCB) (240, 240', 348) angeordnet ist;
Abdichten des Innenraums gegen Umwelteinflüsse;
Aufrechterhalten eines definierten Abstands zwischen der Leiterplatte (240, 240', 348) und der Glasfaserkabelrinne (242, 350); und
Aufrechterhalten der seitlichen Ausrichtung der Leiterplatte (240, 240', 348) und der Glasfaserkabelrinne (242, 350), wobei das Gehäuse (202, 202', 302, 402, 502) einen Sockel (204, 204', 304, 404) umfasst, **dadurch gekennzeichnet, dass**
- die Leiterplatte (PCB) (240, 240', 348) einen optischelektrischen Wandler (192) umfasst, und
- das Gehäuse (202, 202', 302, 402, 502) eine abnehmbare Abdeckung (206, 206', 310, 312) umfasst, die an der Basis (204, 204', 348) befestigt ist,
- wobei die Umwandlungsbaugruppe (238, 238', 346) im Innenraum (208, 314, 504) so angeordnet ist, dass die Glasfaserkabelrinne (242, 350) zwischen der abnehmbaren Abdeckung (206, 206', 310, 312) und der Leiterplatte (240, 240', 348) eingeklemmt ist, wodurch der definierte Abstand und die seitliche Ausrichtung der Glasfaserkabelrinne (242, 350) zur Leiterplatte (240, 240', 348) aufrechterhalten werden, und
wobei ein Dichtungselement (210, 316, 320) an einer Schnittstelle (212, 318, 322) zwischen der abnehmbaren Abdeckung (206, 206', 310, 312) und dem Sockel (204, 204', 304, 404) angeordnet ist, und wobei das Verfahren ferner das Ausstrecken einer Vielzahl von Abstandshaltern (244, 352) von einer Oberfläche (246, 354) der Glasfaserkabelrinne (242, 350) umfasst.

5. Verfahren nach Anspruch 4, wobei die Leiterplatte (240, 240', 348) eine Vielzahl von Aufnahmebohrungen (245, 345) umfasst, und ferner das Positionieren einzelner der Vielzahl von Abstandshaltern (244, 352) in jeweiligen der Vielzahl von Aufnahmebohrungen (245, 345) umfasst.

6. Verfahren nach einem der Ansprüche 4 bis 5, wobei der elektrische Kabelanschluss (214, 324, 408, 509) eine Klemmverschraubung (220, 328, 416) umfasst und wobei der Glasfaserkabelanschluss (216, 326, 410, 510) eine Klemmverschraubung (220, 328, 416) umfasst.

7. Verfahren nach einem der Ansprüche 4 bis 6, das ferner das E-Coating des Gehäuses (202, 202', 302, 402, 502) mit einer korrosionsbeständigen Lösung umfasst.

## Revendications

1. Dispositif de distribution fibre optique / électrique (190, 200, 200', 300, 400, 500), comprenant :
un boîtier (202, 202', 302, 402, 502) définissant un volume intérieur (208, 314, 504) ;
un raccord de câble électrique (214, 324, 408, 509) s'étendant dans le volume intérieur (208, 314, 504) et accessible depuis l'extérieur du boîtier (202, 202', 302, 402, 502), le raccord de câble électrique (214, 324, 408, 509) étant étanchéifié afin d'empêcher la pénétration de poussière et d'eau dans le volume intérieur (208, 314, 504) ;
un raccord de câble à fibres optiques (216, 326, 410, 510) s'étendant dans le volume intérieur (208, 314, 504) et accessible depuis l'extérieur du boîtier (202, 202', 302, 402, 502), le raccord de câble à fibres optiques (216, 326, 410, 510) étant étanchéifié afin d'empêcher la pénétration de poussière et d'eau dans le volume intérieur (208, 314, 504) ; et
un ensemble de conversion (238, 238', 346) disposé dans le volume intérieur (208, 314, 504), l'ensemble de conversion (238, 238', 346) comprenant :
une carte de circuit imprimé (PCB) (240, 240', 348) comportant un circuit d'alimentation électrique (194) ;
un plateau porte-câbles à fibres optique (242, 350) maintenu dans une configuration empilée par rapport à la PCB (240, 240', 348) ;
une distance définie étant maintenue entre la PCB (240, 240', 348) et le plateau porte-câbles à fibres optique (242, 350), et la PCB (240, 240', 348) et le plateau porte-câbles à fibres optique (242, 350) étant maintenus dans un alignement latéral l'un par rapport à l'autre ;
le boîtier (202, 202', 302, 402, 502) comprenant une base (204, 204', 304, 404), **caractérisé en ce que** le dispositif de distribution fibre optique / électrique (190, 200, 200', 300, 400, 500) comprend :
- la carte de circuit imprimé (PCB) (240, 240', 348) comportant un convertisseur optique/électrique (192),
et le boîtier (202, 202', 302, 402, 502) comprenant un couvercle amovible (206, 206', 310, 312) fixé à la base (204, 204', 348) ; et
- le plateau porte-câbles à fibres optique (242, 350) étant pris en sandwich entre le couvercle amovible (206, 206', 310, 312) et la PCB (240, 240', 348), ce qui permet de maintenir la distance définie et l'alignement latéral du plateau porte-câbles à fibres optique (242, 350) par rapport à la PCB (240, 240', 348), et
le dispositif de distribution fibre optique / électrique (190, 200, 200', 300, 400, 500) comprenant en outre un élément d'étanchéité (210, 316, 320) disposé au niveau d'une interface (212, 318, 322) entre le couvercle amovible (206, 206', 310, 312) et la base (204, 204', 304, 404),
le dispositif de distribution fibre optique / électrique (190, 200, 200', 300, 400, 500) comprenant en outre une pluralité d'entretoises (244, 352) s'étendant à partir d'une surface (246, 354) du plateau porte-câbles à fibres optique (242, 350).

2. Le dispositif de distribution fibre optique / électrique (190, 200, 200', 300, 400, 500) selon la revendication 1, dans lequel l'ensemble de conversion (238, 238', 346) peut être positionné vers l'intérieur du volume intérieur (208, 314, 504) et vers l'extérieur de celui-ci.

3. Le dispositif de distribution fibre optique / électrique (190, 200, 200', 300, 400, 500) selon l'une quelconque des revendications 1 à 2, comprenant en outre un composant de dissipation thermique (250, 360), le composant de dissipation thermique (250, 360) étant en liaison de transfert thermique avec l'ensemble de conversion (238, 346).

4. Procédé d'étanchéification d'un dispositif de distribution fibre optique / électrique (190, 200, 200', 300, 400, 500), comprenant :
l'acheminement d'un raccord de câble électrique (214, 324, 408, 509) dans un volume intérieur (208, 314, 504) d'un boîtier (202, 202', 302, 402, 502), le raccord de câble électrique (214, 324, 408, 509) étant accessible depuis l'extérieur du boîtier (202, 202', 302, 402, 502) ;
l'étanchéification du raccord de câble électrique (214, 324, 408, 509) afin d'empêcher la pénétration de poussière et d'eau dans le volume intérieur (208, 314, 504) ;
l'acheminement d'un raccord de câble à fibres optiques (216, 326, 410, 510) dans le volume intérieur (208, 314, 504) du boîtier (202, 202', 302, 402, 502), le raccord de câble à fibres optiques (216, 326, 410, 510) étant accessible depuis l'extérieur du boîtier (202, 202', 302, 402, 502) ;
l'étanchéification du raccord de câble à fibres optiques (216, 326, 410, 510) afin d'empêcher la pénétration de poussière et d'eau dans le volume intérieur (208, 314, 504) ;
la disposition d'un ensemble de conversion (238, 238', 346) dans le volume intérieur (208, 314, 504), l'ensemble de conversion (238, 238', 346) comprenant :
une carte de circuit imprimé (PCB) (240, 240', 348) comportant un circuit d'alimentation électrique (194) ; et
un plateau porte-câbles à fibres optique (242, 350) maintenu dans une configuration empilée par rapport à la PCB (240, 240', 348) ;
l'étanchéification du volume intérieur contre les influences environnementales ;
le maintien d'une distance définie entre la PCB (240, 240', 348) et le plateau porte-câbles à fibres optique (242, 350) ; et
le maintien de l'alignement latéral entre la PCB (240, 240', 348) et le plateau porte-câbles à fibres optique (242, 350), le boîtier (202, 202', 302, 402, 502) comprenant une base (204, 204', 304, 404), **caractérisé en ce que**
- la carte de circuit imprimé (PCB) (240, 240', 348) comporte un convertisseur optique/électrique (192) et
- le boîtier (202, 202', 302, 402, 502) comprend un couvercle amovible (206, 206', 310, 312) fixé à la base (204, 204', 348),
- l'ensemble de conversion (238, 238', 346) étant disposé dans le volume intérieur (208, 314, 504) de telle sorte que le plateau porte-câbles à fibres optique (242, 350) est pris en sandwich entre le couvercle amovible (206, 206', 310, 312) et la PCB (240, 240', 348), ce qui permet de maintenir la distance définie et l'alignement latéral du plateau porte-câbles à fibres optique (242, 350) par rapport à la PCB (240, 240', 348), et
un élément d'étanchéité (210, 316, 320) étant disposé au niveau d'une interface (212, 318, 322) entre le couvercle amovible (206, 206', 310, 312) et la base (204, 204', 304, 404), et le procédé comprenant en outre l'extension d'une pluralité d'entretoises (244, 352) à partir d'une surface (246, 354) du plateau porte-câbles à fibres optique (242, 350).

5. Le procédé selon la revendication 4, dans lequel la PCB (240, 240', 348) comprend une pluralité de trous de réception (245, 345), et comprenant en outre la disposition d'entretoises individuelles (244, 352) parmi la pluralité d'entretoises dans des trous de réception respectifs (245, 345) parmi la pluralité de trous de réception.

6. Le procédé selon l'une quelconque des revendications 4 à 5, dans lequel le raccord de câble électrique (214, 324, 408, 509) comprend un raccord à presse-étoupe (220, 328, 416), et le raccord de câble à fibres optiques (216, 326, 410, 510) comprend un raccord à presse-étoupe (220, 328, 416).

7. Le procédé selon l'une quelconque des revendications 4 à 6, comprenant en outre le revêtement du boîtier (202, 202', 302, 402, 502) au moyen d'une solution résistante à la corrosion par dépôt électrophorétique.
